Europäisches Patentamt

European Patent Office

Office européen des brevets

(19)

(11) Numéro de publication : **0 318 363 B1**

## (12) FASCICULE DE BREVET EUROPEEN

(45) Date de publication du fascicule du brevet :
**08.07.92 Bulletin 92/28**

(51) Int. Cl.⁵ : **G11C 29/00**

(21) Numéro de dépôt : **88402905.9**

(22) Date de dépôt : **18.11.88**

(54) **Procédé de test de cellules de mémoire électriquement programmable et circuit intégré correspondant.**

(30) Priorité : **24.11.87 FR 8716236**

(43) Date de publication de la demande :
**31.05.89 Bulletin 89/22**

(45) Mention de la délivrance du brevet :
**08.07.92 Bulletin 92/28**

(84) Etats contractants désignés :
**DE ES GB IT NL**

(56) Documents cités :
**EP-A- 0 055 906**
**DE-A- 3 637 682**
**US-A- 4 519 076**

(56) Documents cités :
**NEC RESEARCH & DEVELOPMENT, no. 26, juillet 1972, pages 98-109; K. ONODA et al.: "MAS-ROM - Electrically-reprogrammable-ROM with decoder"**

(73) Titulaire : **SGS-THOMSON MICROELECTRONICS S.A.**
**7, Avenue Galliéni**
**F-94250 Gentilly (FR)**

(72) Inventeur : **Devin, Jean**
**Cabinet Ballot-SCHMIT 84, Avenue Kléber**
**F-75116 Paris (FR)**

(74) Mandataire : **Ballot, Paul Denis Jacques et al**
**Cabinet Ballot-Schmit, 7, rue le Sueur**
**F-75116 Paris (FR)**

EP 0 318 363 B1

## Description

L'invention concerne les mémoires électriquement programmables (EPROM). Elle peut concerner également des mémoires programmables et effaçables électriquement.

Les cellules de mémoire utilisées couramment aujourd'hui sont constituées par un transistor à grille flottante dont la grille est reliée à une ligne de mot, le drain à une ligne de bit, et la source à un potentiel de référence qui est en général la masse électrique du circuit.

Une ligne de mot est reliée aux grilles de tous les transistors d'une même ligne ; une ligne de bit est reliée aux drains de tous les transistors d'une même colonne. L'adressage d'une cellule se fait par sélection d'une ligne de bit et d'une ligne de mot.

La programmation de la cellule se fait par injection de charges électriques dans la grille flottante en appliquant un potentiel relativement élevé sur le drain et sur la grille, la source étant à la masse.

La lecture de l'état de la cellule (état programmé ou non programmé) se fait en préchargeant le drain, donc la ligne de bit, à une faible tension, puis en appliquant un potentiel sur la grille et en détectant le courant de décharge de la ligne de bit. Si ce courant est important c'est que la cellule peut facilement être rendue conductrice par le potentiel de lecture ; cela veut dire qu'elle n'est pas programmée. Si le courant est très faible, c'est que la cellule n'est pas rendue conductrice par le potentiel de lecture appliqué à la grille ; cela veut dire qu'elle a été programmée. Un comparateur à seuil détecte le courant et fournit un signal de sortie binaire indiquant l'état de la cellule.

Un problème important que l'on rencontre dans la fabrication et la programmation des mémoires de ce type est le test de la mémoire après programmation ; il faut vérifier que l'état des cellules est bien celui que l'on désire, c'est-à-dire que toutes les cellules qui devraient être programmées ont été programmées, et que celles qui devaient rester vierges (non programmées) le sont restées.

Le test le plus simple consiste à effectuer une opération systématique de lecture de l'état des cellules les unes après les autres, en se plaçant dans les conditions normales de lecture de la mémoire, c'est-à-dire en appliquant les potentiels d'alimentation spécifiés pour la mémoire en mode de lecture. Par ce test on recueille une information binaire sur l'état de chaque cellule.

Mais on s'est rendu compte que l'état de programmation d'une cellule n'est pas une information purement binaire ; la cellule peut être plus ou moins "fortement" programmée, c'est-à-dire que la quantité de charges piégées dans la grille flottante est plus ou moins importante.

Actuellement, on a tendance à programmer très fortement les cellules pour plusieurs raisons : une première est le fait que la quantité de charges piégées ne reste pas éternellement constante ; il y a une certaine perte de charges au cours du temps et la rétention de l'information a donc une durée de vie limitée qu'on souhaite augmenter autant que possible ; on majore donc au départ la quantité de charges piégées. Une deuxième raison est le fait qu'on ne connaît pas exactement la quantité de charges piégées lors d'une opération de programmation : on connaît la tension de programmation et la durée de l'impulsion de programmation, mais il faut à priori majorer ces deux paramètres pour être sûr que même dans les cas les plus défavorables la quantité de charges piégées sera suffisante. Une troisième raison est le fait qu'il faut permettre à l'utilisateur de la mémoire une certaine plage de variations de la tension de lecture appliquée aux lignes de mot ; la tension nominale est par exemple de 5 volts mais il faut que la lecture soit correcte si pour une raison ou pour une autre l'utilisateur applique une tension légèrement supérieure (ex : 6 v) ; mais plus la tension est élevée, plus la cellule va laisser passer du courant, surtout si elle est faiblement programmée ; il y a alors un risque qu'une cellule programmée soit considérée par le comparateur de lecture comme une cellule non programmée, ce qui est inacceptable.

Pour toutes ces raisons, on majore la valeur de la tension de programmation et la durée d'application de cette tension pendant la phase de programmation. Mais majorer la tension implique un surdimensionnement de tous les circuits qui auront à supporter cette tension, d'où un encombrement supplémentaire sur la surface du circuit intégré. Par ailleurs, augmenter la durée de la phase de programmation est très gênant pour les mémoires comportant un grand nombre de cellules puisque la programmation se fait cellule par cellule (ou mot par mot pour les mémoires organisées en mots).

Etant donné que le courant circulant dans la cellule est lié à la programmation plus ou moins forte de celle-ci, on peut chercher à mesurer ce courant précisément pour obtenir une information sur la quantité de charges piégées. Cela permettrait de mieux ajuster ensuite les conditions de programmation ou encore de reprogrammer des cellules dont on constate qu'elles sont insuffisamment programmées.

La mesure de ce courant peut se faire par un test sous pointes pendant la fabrication de la mémoire, alors que celle-ci est encore à l'état de tranche semiconductrice et n'est pas encore découpée en puces individuelles de circuit-intégré, ni encapsulée dans un boîtier. Ce test utilise des circuits spécifiques et des plots de test spécifiques dans le circuit-intégré. Bien entendu, il n'est pas possible de faire ce test sous pointes si la programmation de la mémoire n'a lieu qu'après encapsulation de la mémoire dans un boîtier fermé.

Lorsque la mémoire est encapsulée, les plots spécifiques de test ne sont plus accessibles ; seules sont accessibles les bornes de connexion néccéssaires à l'utilisateur de la mémoire (bornes d'alimentation, bornes d'adressage, bornes de sorties de données), car on cherche à minimiser, pour des raisons d'encombrement et de coût, le nombre de bornes de connexion.

C'est pourquoi, jusqu'à maintenant, on s'est contenté de faire un test binaire de l'état des cellules d'une mémoire encapsulée pour vérifier si elles sont programmées ou non, sans qu'on puisse véritablement accéder à une mesure de la qualité de la programmation pour chacune des cellules.

Il est connue du document US-A-4 519 076 un procédé de test qui comporte toutes les caractéristiques du préambule de la revendication 1. Le circuit correspondant comporte un circuit logique pour recevoir un signal de mode de test et pour connecter la borne d'entrée-sortie directement à la ligne de bit.

Il a été proposé un procédé de test amélioré qui résoud ces problèmes et qui permet non seulement de s'assurer si les cellules sont programmées ou non, mais aussi notamment :

- de mieux définir les plages de valeurs de tension de lecture pour lesquelles le comparateur de lecture donnera une indication exacte sur l'état de la cellule ;
- de mieux définir les tensions et durées de programmation suffisantes pour programmer les cellules avec une durée de rétention désirée.

Pour cela l'invention propose un procédé de test d'une mémoire électriquement programmable comprenant des cellules adressables en lecture et en programmation par des lignes de mot, l'état binaire des cellules pouvant être lu ou écrit à partir de lignes de bit, et une borne de programmation étant prévue pour recevoir et appliquer sur une ligne de bit une tension de programmation plus élevée que les tensions appliquées en mode de lecture, selon ce procédé, en vue de tester une cellule, on applique une tension de lecture sur une ligne de mot, on connecte la ligne de bit à la borne de programmation, on relie cette borne à une source de tension de test de valeur beaucoup plus faible que la tension de programmation et on mesure le courant circulant entre cette borne et la source de tension du test.

Ainsi, on peut mesurer le courant dans chacune des cellules, en fonction de la tension de lecture appliquée à la ligne de mot et en fonction de la tension appliquée à la ligne de bit à partir de la borne de programmation. Cette mesure se fait sur une mémoire encapsulée puisque la borne de programmation est nécessairement accessible de l'extérieur pour permettre la programmation de la mémoire.

Pour mettre en oeuvre pratiquement ce procédé, on prévoit un très petit nombre de portes logiques permettant de passer d'un mode de lecture normale (n'utilisant pas la borne de programmation) à un mode de test (utilisant cette borne mais d'une manière différente de l'utilisation en mode de programmation).

Plus précisément, on prévoit que le circuit-intégré comporte un circuit logique relié à la borne de programmation, ainsi qu'à une borne d'alimentation fournissant les tensions de lecture, et relié également à une borne de commande de lecture/écriture, ce circuit recevant par ailleurs un signal de mode de test, pour appliquer en mode de test la tension de lecture présente sur la borne d'alimentation à la ligne de mot et la tension présente sur la borne de programmation à la ligne de bit.

En mode de programmation la tension élevée présente sur la borne de programmation est appliquée à la fois sur la ligne de mot et sur la ligne de bit. En mode de lecture, la tension de lecture présente sur la borne d'alimentation est appliquée à la ligne de mot et une faible tension, générée de manière interne, est appliquée à la ligne de bit.

Le signal de mode de test peut être appliqué à partir de l'extérieur par une borne de mode de test spécifique. Si on veut éviter cette borne, on peut engendrer le signal de test par exemple à partir d'un détecteur de niveau connecté à une borne du circuit intégré ; cette borne peut être la borne de programmation elle-même qui serait raccordée à un circuit de détection de niveau qui fournirait un signal de test lorsque le niveau de tension mesuré sur cette borne est compris entre deux valeurs spécifiées beaucoup plus faibles que la tension de programmation.

D'autres caractéristiques et avantages de l'invention apparaîtront à la lecture de la description détaillée qui suit et qui est faite en référence aux dessins annexés dans lesquels :
- la figure 1 décrit une structure de mémoire classique,
- la figure 2 décrit une structure de mémoire incorporant l'invention.

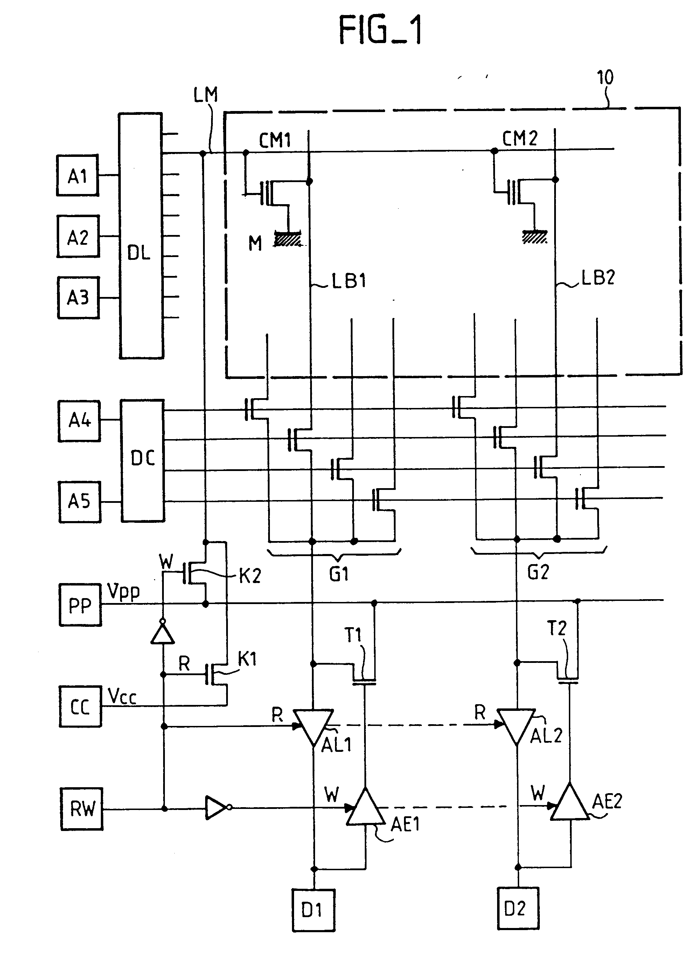

Pour mieux faire comprendre l'invention, on a représenté à la figure 1 un exemple de structure de mémoire dans laquelle l'invention peut s'appliquer.

La mémoire est réalisée sur un substrat de circuit intégré comprenant d'une part un réseau 10 de cellules de mémoire agencées en lignes et colonnes, et d'autre part des circuits périphériques et des plots d'accès pour la connexion du circuit intégré à des bornes extérieures. Ces bornes sont accessibles lorsque le circuit intégré est encapsulé dans un boîtier.

Les cellules de mémoire individuelles du réseau 10 sont constituées par des transistors à grille flottante connectés à des lignes de mot et des lignes de bit.

A titre d'exemple on a représenté deux cellules de mémoire CM1 et CM2 connectées à une même ligne de mot LM. Le transistor de la cellule CM1 a sa grille de commande reliée à la ligne de mot LM, son drain relié à une ligne de bit LB1 et sa source reliée à une masse électrique M. Le transistor de la cellule CM2 a sa grille de commande reliée à la ligne de mot LM, son drain relié à une ligne de bit LB2, et sa source à la masse. Tous les transistors d'une même ligne du réseau 10 ont leur grille reliée à une même ligne de mot et tous les transistors d'une même colonne du réseau ont leur drain relié à une même ligne de bit.

La mémoire est organisée en n lignes de m mots de p bits chacun. Un décodeur de ligne DL permet de sélectionner une ligne de mot désignée, telle que la ligne LM, et d'appliquer une tension sur cette ligne ; un décodeur de colonne DC permet de sélectionner un mot parmi m.

Pour permettre cette sélection, les lignes de bit sont organisées en groupes distincts tels que G1 et G2 et le décodeur de colonne sélectionne une ligne de bit déterminée dans chacun des groupes. Dans l'exemple représenté, on a deux groupes de quatre colonnes chacun et le decodeur de colonne sélectionne par exemple la deuxième ligne de bit de chaque groupe, c'est à dire la ligne LB1 pour le premier groupe et la ligne LB2 pour le deuxième.

La sélection effectuée par le décodeur de colonne DC consiste à connecter les lignes de bit choisies chacune à l'entrée d'un amplificateur de lecture, AL1 pour le groupe G1, AL2 pour le groupe G2. La sortie de l'amplificateur de lecture est connectée à un plot d'entrée/sortie de données, D1 pour l'amplificateur de lecture AL1, et D2 pour l'amplificateur AL2. Les amplificateurs AL1 et AL2 sont des amplificateurs à grand gain fonctionnant comme comparateurs à seuil.

Le décodeur de lignes DL et le décodeur de colonne DC reçoivent des signaux d'adressage par des plots d'entrée d'adresses, A1, A2, A3 pour le décodeur de lignes, et A4, A5 pour le décodeur de colonnes. L'application de signaux d'adressage sur les entrées d'adresses A1 à A5 permet de connecter les cellules CM1 et CM2, correspondant à un mot sélectionné, aux plots d'entrée/sortie de données D1 et D2.

Les plots d'entrée/sortie D1 et D2 sont reliés par ailleurs aux entrées d'amplificateurs d'écriture, AE1 pour le plot D1, et AE2 pour le plot D2.

L'amplificateur AE1 commande un commutateur T1 permettant de relier la ligne de bit sélectionnée dans le groupe G1 à une borne de programmation PP destinée à recevoir, en phase de programmation ou "écriture", une tension de programmation Vpp (12 à 15 volts environ), plus élevée que les tensions d'alimentation normales du circuit.

De même, l'amplificateur d'écriture AE2 commande un commutateur T2 permettant de relier la ligne de bit sélectionnée dans le groupe G2 à la borne de programmation PP.

Le circuit intégré de la figure 1 comporte encore un plot RW de commande de lecture/écriture destiné à recevoir un signal binaire indiquant si l'on désire lire le contenu d'un mot de mémoire ou au contraire écrire un contenu dans ce mot.

Enfin, un plot d'alimentation CC permet d'amener au circuit une tension d'alimentation normale Vcc (5 volts par exemple) qui est en particulier la tension de lecture qu'on applique sur les lignes de mot pendant la phase de lecture.

En phase de lecture, les amplificateurs de lecture AL1, AL2 sont validés, les amplificateurs d'ecriture AE1 et AE2 sont inhibés et les commutateurs T1 et T2 sont ouverts. Réciproquement, en phase de programmation, les amplificateurs d'écriture AE1, AE2, sont validés, les amplificateurs de lecture AL1, AL2 sont inhibés les commutateurs T1 et T2 sont ouverts ou fermés selon l'état des données présentées sur les plots D1, D2, c'est à dire selon la valeur du mot binaire à écrire dans la mémoire.

Par ailleurs, en phase de lecture, la tension d'alimentation Vcc présente sur le plot d'alimentation CC, est appliquée à la ligne de mot LM, par l'intermédiaire d'un commutateur K1 commandé par le signal de mode de lecture R présent sur la borne RW. Inversement, pendant la phase de programmation, c'est la tension de programmation Vpp présente sur le plot de programmation PP qui est appliquée à la ligne de mot LM, par l'intermédiaire d'un commutateur K2 commandé par le signal de mode d'écriture W, complément logique du signal R.

Ainsi, en phase de lecture, une tension de lecture Vcc (ou approximativement Vcc) est appliquée à la ligne de mot LM par l'intermédiaire du commutateur K1, après précharge des lignes de bit à une tension de précharge faible (1 à 2 volts par exemple) par un circuit de précharge non représenté ; le courant qui en résulte dans les lignes de bit sélectionnées dépend de l'état programmé ou non programmé de la cellule, et il est détecté par les amplificateurs de lecture qui fournissent sur les plots de données D1 et D2 l'information désirée sur le contenu d'un mot de la mémoire.

En phase de programmation, une tension approximativement égale à la tension de programmation Vpp est appliquée sur certaines des lignes de bit seulement, en fonction du signal binaire présent sur les plots de données D1 et D2, par l'intermédiaire des amplificateurs d'écriture AE1 et AE2 et des commutateurs T1 et T2. En même temps, la tension de programmation Vpp (ou approximativement cette tension) est appliquée à la ligne de mot sélectionnée par l'intermédiaire du commutateur K2.

Selon l'invention, on conserve ces deux configurations de fonctionnement en lecture et en programmation, et on introduit une configuration différente en mode de test pour diriger vers la borne Vpp le courant circulant dans les lignes de bit.

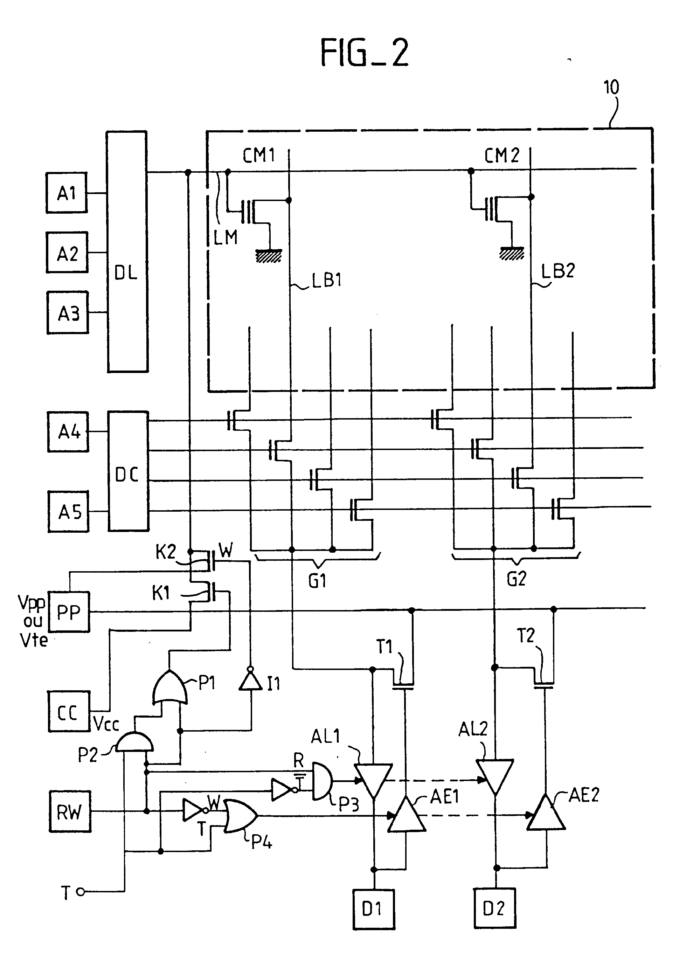

Il en résulte de petites modifications de circuit et un exemple de réalisation de ces modifications est représenté à la figure 2. Sur cette figure, les éléments identiques à ceux de la figure 1 portent les mêmes références et ne seront pas décrits à nouveau.

Le mode de lecture et le mode de programmation fonctionnent exactement comme dans le cas de la figure 1, sous la commande du signal de mode de lecture/écriture présent sur la borne RW.

Un mode de test est prévu et est déterminé par un signal logique T. Le signal de mode de test T peut être appliqué depuis l'extérieur du circuit, par une borne spécifique de commande de mode de test, ou bien il peut être engendré de manière interne à partir d'une information appliquée sur les bornes existantes telles que celles de la figure 1.

Dans un exemple simple de réalisation, le circuit comporte un détecteur de niveau de tension connecté à la borne de programmation PP. Si le niveau de tension sur cette borne est compris entre deux niveaux spécifiés, par exemple 1 volt et 3 volts, alors le détecteur de niveau fournit un signal logique de mode de test T dont l'état logique indique qu'on est en mode de test.

Si au contraire le niveau de tension sur la borne PP est en dehors de la plage spécifiée, par exemple s'il est nul ou s'il est égal à Vpp, le détecteur de niveau connecté à la borne PP fournit un signal indiquant qu'on n'est pas en mode de test.

Dans un autre exemple de realisation, on peut encore prévoir que c'est le niveau de tension présent sur une autre borne du circuit qui est porté à une valeur supérieure à la normale et qui est détecté par un circuit fournissant le signal de mode de test.

Dans l'exemple de réalisation décrit ici, on considèrera que le mode de test ne peut être utilisé que si la borne de commande de lecture/écriture RW reçoit un niveau logique correspondant au mode de lecture. En d'autres mots, on prévoit qu'au moment du test on doit imposer sur la borne RW un niveau logique déterminé, l'autre niveau étant incompatible avec le mode de test. Mais une solution différente pourrait être envisagée, par exemple une solution dans laquelle le niveau logique de la borne RW est indifférent ou correspond à la commande d'écriture.

Selon l'invention, en mode de test, la tension Vcc présente sur la borne d'alimentation CC est appliquée, par l'intermédiaire du commutateur K1, à la ligne de mot sélectionnée LM, comme elle est appliquée à cette ligne en mode de lecture. En même temps les amplificateurs de lecture AL1, AL2 sont inhibés (contrairement à ce qui se passe en mode de lecture), et les amplificateurs d'écriture AE1, AE2 sont validés pour commander la fermeture de l'un des commutateurs T1, T2 en fonction d'un signal logique approprié appliqué sur un plot d'entrée correspondant D1 ou D2. Le ou les autres commutateurs restent ouverts.

Par conséquent en mode de test, une seule ligne de bit est reliée au plot de programmation PP : cette ligne est sélectionnée d'une part par une adresse de colonne introduite par les plots A4, A5, et d'autre part par sélection d'un seul plot de données sur lequel on applique un signal logique d'un premier niveau logique, les autres plots recevant un niveau logique complémentaire.

Enfin, en mode de test, on relie, à l'extérieur du circuit intégré, la borne de programmation PP à une source de tension de test, de faible valeur par rapport à la tension de programmation Vpp, par exemple une tension Vte de 2 volts. On mesure, à l'extérieur du circuit, le courant qui circule entre la source de tension de test et la borne de programmation PP.

Ce courant est celui qui circule dans la ligne de bit sélectionnée. Il peut être mesuré soit pour une tension de test Vte et une tension de lecture Vcc bien définies, soit en faisant varier l'une ou l'autre de ces tensions pour relever une courbe donnant des indications sur

– l'état de programmation de la cellule
– l'importance quantitative des charges piégées dans la grille flottante.

Cette courbe peut être relevée cellule par cellule en adressant successivement toutes les cellules par les plots d'adressage A1 à A5 et les plots de données D1 et D2.

Sur la figure 2 on a représenté à titre d'exemple des circuits logiques permettant de passer en phase de test, de lecture ou de programmation, en fonction du signal de mode de test T et du signal de commande de mode de lecture/écriture présent sur la borne RW. On a supposé que si le signal R de mode de lecture est au niveau logique haut on passe en mode de lecture, que si le signal complémentaire W est au niveau haut on passe en mode de programmation, et que si on a à la fois R et T au niveau haut on est en mode de test, la combinaison W et T au niveau haut étant interdite.

C'est ainsi que l'interrupteur K2 est commandé par le signal W au niveau haut par l'intermédiaire d'un inverseur I1 ; l'interrupteur K1 est commandé par une porte OU P1 recevant d'une part le signal R (pour que l'interrupteur K1 se ferme en mode de lecture) et d'autre part la sortie d'une porte ET P2 qui reçoit les signaux R et T (pour que l'interrupteur se ferme en mode de test seulement à condition que R soit au niveau haut).

Les amplificateurs de lecture AL1, AL2 sont validés par la sortie d'une porte ET P3 qui reçoit d'une part le signal R et d'autre part le complément du signal T (pour que les amplificateurs de lecture soient validés en mode de lecture mais pas en mode de test).

Les amplificateurs d'écriture AE1, AE2 sont validés par la sortie d'une porte OU P4 recevant le signal W et le signal T (pour qu'ils soient validés en mode de programmation et en mode de test).

La description ci-dessus a été faite pour une mémoire organisée en 8 lignes (3 plots d'adresse de ligne A1, A2, A3) de 4 mots (2 plots A4, A5 d'adresse de colonne) de 2 bits (2 plots D1, D2 d'entrée/sortie de données) ; elle est applicable plus généralement à n lignes de m mots de p bits.

## Revendications

1. Procédé de test d'une mémoire électriquement programmable comprenant des cellules (CM1, CM2) adressables en lecture et en programmation par des lignes de mots (LM), l'état binaire des cellules pouvant être lu ou écrit à partir de lignes de bit (LB1, LB2), et une borne de programmation (PP) étant prévue pour recevoir et appliquer sur une ligne de bit une tension de programmation (Vpp) plus élevée que les tensions appliquées en mode de lecture, selon ce procédé, en vue de tester une cellule, on applique une tension de lecture (Vcc) sur une ligne de mot (LM), on connecte la ligne de bit à une borne, on relie cette borne à une source de tension de test (Vte) de valeur beaucoup plus faible que la tension de programmation (Vpp), et on mesure le courant circulant entre cette borne et la source de tension de test, ce procédé étant caractérisé en ce que cette borne est le borne de programmation.

2. Procédé de test selon la revendication caractérisé en ce qu'on fait varier la tension de lecture (Vcc) et on relève la courbe de variation du courant en fonction de cette tension.

3. Procédé de test selon l'une des revendications 1 et 2, dans lequel la mémoire est organisée en n lignes de m mots de p bits, les données correspondant à chaque mot de mémoire pouvant être lues ou inscrites à partir de p plots de données (D1, D2), caractérisé en ce que le test comprend une opération de sélection d'un bit de donnée parmi p, cette sélection se faisant par application d'un signal logique d'un premier niveau sur l'un des plots de données et un deuxième niveau, complémentaire du premier, sur tous les autres plots de données.

4. Procédé de test selon l'une des revendications précédentes caractérisé en ce que l'on applique un signal spécifique sur au moins une borne extérieure du circuit intégré, pour indiquer qu'on est en mode de test.

5. Procédé de test selon l'une des revendications 1 à 3, caractérisé en ce qu'on n'applique pas de signal spécifique indiquant qu'on est en mode de test, et en ce qu'on détecte, à l'intérieur du circuit intégré, la présence sur la borne de programmation (PP) d'une tension comprise entre deux niveaux de tension spécifiés très inférieurs à la tension de programmation (Vpp).

6. Circuit intégré de mémoire électriquement programmable, comprenant un réseau de cellules de mémoire (CM1, CM2) adressables en lecture et en programmation par des lignes de mot (LM), l'état des cellules pouvant être lu ou inscrit à partir de lignes de bit (LB1, LB2), et une borne de programmation (PP) étant prévue pour recevoir et appliquer sur une ligne de bit une tension de programmation (Vpp) plus élevée que les tensions appliquées en mode de lecture, ce circuit comporte un premier circuit logique (P1, P2, I1) pour recevoir un signal de mode de test (T) et pour aiguiller vers la ligne de mot (LM) soit la tension présente sur la borne de programmation, en mode de programmation, soit une tension de lecture, en mode de lecture ou de test, et un deuxième circuit logique (P3, P4) pour autoriser, en mode de programmation et en mode de test, la connection entre une ligne de bit spécifiée et la borne de programmation (PP).

7. Circuit selon la revendication 6, caractérisé en ce que le deuxième circuit logique inhibe en mode de test un amplificateur de lecture (AL1, AL2) connecté entre les lignes de bit et un plot d'entrée/sortie de données (D1, D2).

8. Circuit selon l'une des revendications 6 et 7 caractérisé en ce qu'il comporte une borne de mode de test pour recevoir un signal de mode de test (T).

9. Circuit selon l'une des revendications 6 à 8 caractérisé en ce qu'il comporte un circuit de détection de niveau de tension, fournissant un signal de mode de test (T) lorsque la tension présente sur la borne de programmation (PP) est comprise entre deux niveaux spécifiés largement inférieurs à la tension de programmation (Vpp).

## Patentansprüche

1. Verfahren zum Testen von elektrisch programmierbaren Speichern mit für das Lesen und das Programmieren durch Wortleitungen (LM) zugänglichen Zellen, deren binärer Zustand durch Bitleitungen entweder eingelesen oder eingeschrieben wird, wobei ein Programmanschluß (PP) zum Empfangen und Anlegen einer Programmierspannung (Vpp) auf einer Bitleitung vorgesehen ist, die höher ist als die Spannungen, die beim Lesebetrieb angelegt werden, wobei man bei diesem Verfahren im Hinblick auf das Testen einer Zelle eine Lesespannung (Vcc) auf einer Wortleitung (LM) anlegt, die Bitleitung mit einem Anschluß verbindet, diesen Anschluß mit einer Test-Spannungsquelle (Vte) verbindet, deren Wert wesentlich geringer ist als derjenige der Programmierspannung (Vpp) und den Strom mißt, der zwischen diesem Anschluß und der Test-Spannungsquelle fließt, dadurch gekennzeichnet, daß dieser Anschluß der Programmieranschluß ist.

2. Verfahren nach Anspruch 1, dadurch gekennzeichnet, daß man die Lesespannung (Vcc) variiert und die Stromveränderungskurve als Funktion dieser Spannung mißt.

3. Verfahren nach Anspruch 1 oder 2, bei welchem der Speicher organisiert ist in n Zeilen mit m Worten und p Bits, wobei die einem jeden Speicherwort entsprechenden Daten ausgehend von p Datenstellen (D1, D2) eingelesen oder eingeschrieben werden können, dadurch gekennzeichnet, daß der Test die Auswahl eines Datenbits unter p umfaßt, wobei diese Auswahl zustandekommt durch Anwendung eines logischen Signals mit einem ersten Niveau an einer der Datenstellen und mit einem zweiten Niveau, komplimentär zum ersten Niveau an allen anderen Datenstellen.

4. Verfahren nach einem der vorhergehenden Ansprüche, dadurch gekennzeichnet, daß man ein spezifisches Signal an zumindest einem äußeren Anschluß der integrierten Schaltung anlegt, um anzuzeigen, daß man im Testbetrieb ist.

5. Verfahren nach einem der Ansprüche 1 bis 3, dadurch gekennzeichnet, daß man kein spezifisches Signal anlegt, welches anzeigt, daß man im Testbetrieb ist, und daß man im Inneren der integrierten Schaltung an den Programmieranschluß (PP) das Vorhandensein einer Spannung zwischen zwei spezifischen Spannungsniveaus, die sehr viel niedriger sind als die Programmierspannung (Vpp) aufsucht.

6. Integrierte Schaltung von elektrisch programmierbaren Speichern, umfassend ein Speicherzellennetzwerk (CM1, CM2), das für das Lesen und Programmieren durch Wortleitungen (LM) zugänglich ist, wobei der Zustand der Zellen ausgehend von Bit-Leitungen (LB1, LB2) eingelesen oder eingeschrieben werden kann sowie einen Programmieranschluß (PP), der vorgesehen ist, um auf einer Bitleitung eine Programmierspannung (Vpp), die höher ist als die Spannungen im Lesebetrieb sind, zu empfangen und anzulegen und wobei diese Schaltung einen ersten logischen Kreis (P1, P2, I1) umfaßt, um ein Testbetrieb-Signal (T) zu empfangen und um auf die Wortleitung (LM) entweder eine am Programmieranschluß im Programmierbetrieb vorhandene Spannung oder eine im Lesebetrieb vorhandene Lesespannung oder eine Testspannung anzulegen sowie einen zweiten logischen Kreis (P3, P4) umfaßt, um im Programmierbetrieb und im Testbetrieb die Verbindung zwischen einer spezifischen Bitleitung und dem Programmieranschluß (PP) zuzulassen.

7. Schaltung nach Anspruch 6, dadurch gekennzeichnet, daß der zweite logische Kreis im Testbetrieb einen Leseverstärker (AL1, AL2) hemmt, der zwischen den Bitleitungen und einer Eingangs-/Ausgangs Datenstelle (D1, D2) angeordnet ist.

8. Schaltung nach Anspruch 6 oder 7, dadurch gekennzeichnet, daß sie einen Testbetriebanschluß aufweist, um ein Testbetriebssignal (T) zu empfangen.

9. Schaltung nach einem der Ansprüche 6 bis 8, dadurch gekennzeichnet, daß sie eine Schaltung zur Feststellung des Spannungsniveaus umfaßt, die ein Testbetriebsignal (T) liefert, wenn die am Programmieranschluß (PP) anliegende Spannung sich zwischen zwei spezifischen Niveaus befindet, die weit unter der Programmierspannung (Vpp) liegen.

## Claims

1. A method for testing an electrically programmable memory comprising cells (CM1, CM2) addressable during reading and during programming th rough word lines (LM), it being possible to read or write the binary state of the cells through bit lines (LB1, LB2) and a programming terminal (PP) being provided in order to receive and apply on a bit line a programming voltage (Vpp) greater than than the voltages applied in the reading mode, according to which method, in order to test a cell a read voltage (Vcc) is applied on a word line (LM), the bit line is connected to a terminal and this terminal is connected to a source of a test voltage (Vte) having a value much smaller than the programming voltage (Vpp), and the current passing between this terminal and the source of the test voltage is measured, this method being characterized in that the said terminal is the programming terminal.

2. A method for testing as claimed in claim 1, characterized in that the read voltage (Vcc) is varied and the curve showing the current variation as a function of this voltage is obtained.

3. A method for testing as claimed in either one of claims 1 and 2, in which the memory is organized in n lines of m words and p bits, it being possible to read or write the data corresponding to each word of the memory through p data terminals (D1, D2), characterized in that the test comprises an operation of selecting one data bit from p, this selection being performed by applying a logic signal having a first level to one of the data terminals and applying a second level, complementary to the first, to all the other data terminals.

4. A method for testing as claimed in any one of the preceding claims, characterized in that a specific signal is applied to at least one external terminal of the integrated circuit in order to indicate that test mode is in use.

5. A method for testing as claimed in any one of claims 1 to 3, characterized in that no specific signal indicating that test mode is in use is applied and in that, inside the integrated circuit, the presence of a voltage comprised between two specified voltage levels which are much lower than the programming voltage (Vpp) is detected on the programming terminal (PP).

6. An electrically programmable integrated memory circuit comprising a network of memory cells (CM1, CM2) addressable during reading and during programming through word lines (LM), it being possible to read or write the state of the cells th rough bit lines (LB1, LB2) and a programming terminal (PP) being provided in order to receive and apply on a bit line a programming voltage (Vpp) greater th an than the voltages applied in the reading mode, this circuit comprising a first logic circuit (P1, P2, I1) for receiving a test mode signal (T) and for switching to the word line (LM) eith er the voltage present on the programming terminal, during the programming mode, or a read voltage, during the read or the test mode, and a second logic circuit (P3, P4) for authorising, during the programming mode and during the test mode, the connection between a specified bit line and the programming terminal (PP).

7. A circuit as claimed in claim 6, characterized in that the second logic circuit inhibits, in the test mode, a read amplifier (AL1, AL2) connected between the bit lines and an input/output data terminal (D1, D2).

8. A circuit as claimed in either one of claims 6 and 7, characterized in that it comprises a test mode terminal for receiving a test mode signal (T).

9. A circuit as claimed in any one of claims 6 to 8, characterized in th at it comprises a voltage level detection circuit supplying a test mode signal (T) when the voltage present on the programming terminal (PP) is between two specified levels which are much lower than the programming voltage (Vpp).

# FIG_1

# FIG_2